# EUROPÄISCHE PATENTSCHRIFT

(11) **EP 0 888 705 B1**
(45) Veröffentlichungstag und Bekanntmachung des Hinweises auf die Patenterteilung: **26.11.2003**
(21) Anmeldenummer: 97943749.8
(22) Anmeldetag: 09.09.1997
(51) Int. Cl.: H05K 5/00, B29C 45/14, H01R 13/405

(54) **ELEKTRISCHES GERÄT**
ELECTRIC APPARATUS
APPAREIL ELECTRIQUE

(30) Priorität: 21.12.1996 DE 19653831
(43) Veröffentlichungstag der Anmeldung: 07.01.1999
(73) Patentinhaber: ROBERT BOSCH GMBH, 70442 Stuttgart (DE)
(72) Erfinder: HUBER, Elmar, D-72793 Pfullingen (DE); LITZINGER, Rolf, D-72379 Hechingen (DE); RAICA, Thomas, D-72379 Hechingen (DE)
(86) Internationale Anmeldenummer: DE9701998
(87) Internationale Veröffentlichungsnummer: WO98028960

(56) Entgegenhaltungen:
- EP-A- 0 708 583
- WO-A-93/14614
- DE-A- 3 310 477
- PATENT ABSTRACTS OF JAPAN vol. 011, no. 295 (M-626), 24.September 1987 & JP 62 087314 A (TOSHIBA CORP), 21.April 1987,

## Beschreibung

### Stand der Technik

Die Erfindung geht aus von einem elektrischen Gerät, insbesondere von einem Schalt- und Steuergerät für Kraftfahrzeuge nach der Gattung des Anspruchs 1.

Durch die DE 33 10 477 A1 ist ein solches Gerät bekannt. Dieses weist als Hauptkomponenten ein quaderförmiges Gehäuse, ein in dem Gehäuse befindlichen Bauteileträger, eine an einer stirnseitigen Öffnung aus dem Gehäuse herausragende Steckerleiste und einen rahmenförmigen Haltekörper auf, der die Steckerleiste unter teilweiser Überdeckung ringförmig umgibt und diese an dem Gehäuse fixiert.

Die Steckerleiste stellt ein separates, auswechselbares Teil dar und besteht aus einem Steckerkörper aus Kunststoff, in dem Lagerabschnitte von Kontaktelementen gelagert sind, wobei die Endabschnitte der Kontaktelemente einerseits Kontaktabschnitte zur Kopplung mit Gegenkontaktelementen eines Gegensteckers und andererseits Anschlußabschnitte zum Anschluß an den Bauteileträger bilden.

Die Steckerleiste wird zur Montage an dem Gerät mit Schrauben an dem Haltekörper und dieser mit Rastverbindungen an dem Gehäuse befestigt. Diese Art der Ausstattung eines elektrischen Geräts mit Kontaktelementen als Anschlußmittel im Rahmen einer separaten Steckerleiste ist fertigungstechnisch ungünstig und mit hohen Herstellkosten verbunden, weil zuerst für sich in einem vorgelagerten Prozeß die Steckerleiste erstellt, geprüft und zwischengelagert werden muß. Nach der Zuführung der Steckerleiste zu dem Gerät ist in Montageschritten die Steckerleiste an dem Gerät zu befestigen.

Wird das Gerät hohen mechanischen Belastungen ausgesetzt, beispielsweise, weil es direkt an einem verbrennungsmotor des Kraftfahrzeugs angebracht ist, so sind zusätzliche Sicherungsmaßnahmen, beispielsweise Sicherungslack an den Schraubverbindungen vorzusehen, um einer Zerrüttung der elektrischen Verbindungen zwischen den Anschlußabschnitten der Kontaktelemente und Anschlußpunkten des Bauteileträgers vorzubeugen. Dies führt in nachteiliger Weise zu einer kostenintensiven Fertigung des Geräts.

### Vorteile der Erfindung

Das erfindungsgemäße elektrische Gerät mit den kennzeichnenden Merkmalen des Anspruchs 1 hat demgegenüber den Vorteil, daß die zuvor erwähnten Unzulänglichkeiten in zufriedenstellendem Maß vermieden werden. Dazu ist in einer Ausnehmung eines Gehäuses des Geräts ein Halteelement angebracht, das quer zu einer Kopplungsrichtung von Kontaktelementen des Geräts in die Ausnehmung hineinragt.

Mit dem stoffschlüssigen Einbringen eines Füllkörpers in die Ausnehmung, der die Ausnehmung verschließt und in Formschluß mit Lagerabschnitten der Kontaktelemente und dem Halteteil ist, ist ein Steckergehäuse geschaffen, das als integraler Bestandteil des Gehäuses des elektrischen Geräts auch unter erhöhten mechanischen Belastungen dem Gerät eine hohe Betriebssicherheit verleiht und eine kostengünstige Fertigung des Geräts ermöglicht.

Durch die in den Unteransprüchen aufgeführten Maßnahmen sind vorteilhafte Weiterbildungen des im Anspruch 1 angegebenen elektrischen Geräts möglich.

### Zeichnung

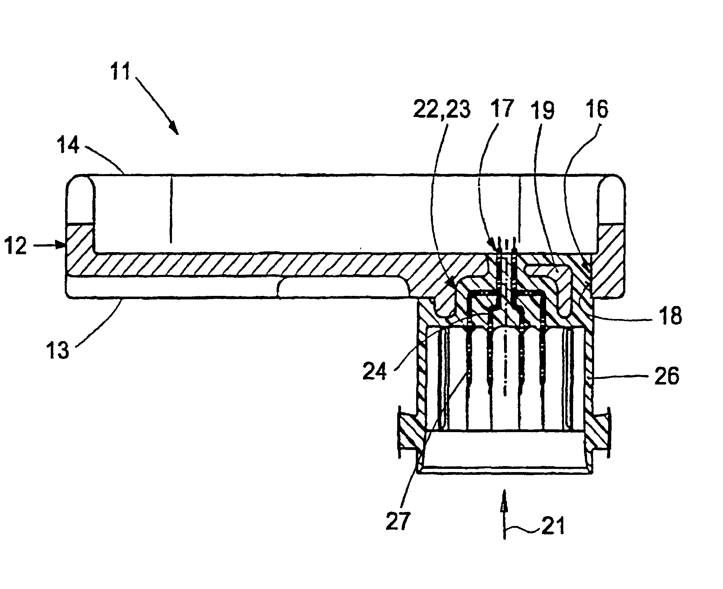

Ein Ausführungsbeispiel der Erfindung ist in der Zeichnung dargestellt und in der nachfolgenden Beschreibung näher erläutert. In einer Schnittdarstellung zeigt die Figur Teile des Gehäuses und des Steckergehäuses des elektrischen Geräts.

### Beschreibung des Ausführungsbeispiels

Ein elektrisches Gerät 11, insbesondere ein Schalt- und Steuergerät für ein Kraftfahrzeug, weist nach der Figur ein Gehäuse 12 auf, das quaderförmig ist und aus Metall besteht, aber alternativ auch aus Kunststoff gefertigt sein kann.

In dem Gehäuse 12 befindet sich in nicht dargestellter Weise ein Bauteilträger, der mit elektrischen und/oder elektronischen Bauelementen bestückt und der zu deren Anschluß elektrische Anschlußpunkte aufweist.

An einem Boden 13 des Gehäuses 12, der einer mit einem Dekkel verschließbaren Deckfläche 14 des Gehäuses 12 gegenüberliegt, ist eine Ausnehmung 16, alternativ auch mehrere Ausnehmungen 16 ausgebildet. Die Ausnehmung 16 ist zur Aufnahme von Kontaktelementen 17 vorgesehen, die mit endseitigen Anschlußabschnitten mit zugeordneten Anschlußpunkten des Bauteileträgers verbunden sind. Die Form der Ausnehmung 16 ist von der Anordnung der Kontaktelemente 17 abhängig; ist deren Anordnung reihenförmig, so weist die Ausnehmung 14 die Form eines Langloches auf.

An einer Innenwandung 18 der Ausnehmung 16 ist als Teil des Gehäuses 12 ein Halteelement 19 ausgebildet. Das Halteelement 19 in Form eines Steges ragt rechtwinklig zu einer Kopplungsrichtung der Kontaktelemente 17 längs eines Pfeiles 21 in die Ausnehmung 16.

In die Ausnehmung 16 ist ein Füllkörper 22 zur Bildung eines Steckergehäuses 23 stoffschlüssig über eine Kunststoffeinspritzung einbringbar. Dazu sind die Kontaktelemente 17, das Halteelement 19 und die an die Ausnehmung 16 angrenzenden Abschnitte des Gehäuses 12 in nicht dargestellter Weise als Einlegeteile in ein Kunststoffspritzwerkzeug eingebracht.

Mit der Kunststoffeinspritzung werden Lagerabschnitte 24 der Kontaktelemente 17 und das Halteelement 19 von Kunststoff umschlossen, der an der Innenwandung 18 eine begrenzende Fläche des Gehäuses 12 findet.

Nach dem Ausformen des Kunststoffspritzwerkzeugs ist das mit den Kontaktelementen 19 versehene Steckergehäuse 23 als integraler Bestandteil des Gehäuses 12 des elektrischen Geräts 11 gebildet. Das Steckergehäuse 23, in dem die Kontaktelemente 17 über die Lagerabschnitte 23 ortsfest gelagert sind, ist seinerseits durch den Einschluß des Halteelements 19 und durch die Angrenzung an die Innenwandung 18 ein unverrückbares Teil des Gehäuses 12.

Das Steckergehäuse 23 weist eine von dem Gehäuse 12 abstehende, bundförmige Aufnahme 26 auf, in der Kontaktabschnitte 27 der Kontaktelemente 17 zur Kopplung mit Gegenkontaktelementen eines Gegensteckers angeordnet sind.

Mit der Bildung des Steckergehäuse 23 durch einen Kunststoffspritzvorgang lassen sich an dem Steckergehäuse 23 in einfacher Weise Komponenten wie Kabelabgänge, Anschraub- und Wärmekontaktflächen, mechanische Schutzelemente und Räume zur Unterbringung von elektrischen Schaltungen ausbilden.

Durch die vorbeschriebene Einbindung des Steckergehäuses 23 in das Gehäuse 12 des elektrischen Geräts 11 ist die mechanische Stabilität zwischen dem Gehäuse 12, in der der Bauteileträger gelagert ist und das mit den Kontaktelementen 17 versehene Steckergehäuse 23, das die Kontaktierung nach auβen trägt, so hoch, daß verbindende Elemente zwischen den Anschlußabschnitten der Kontaktelemente 17 und den Anschlußpunkten des Bauteileträgers, wie Bonds, Flexfolien oder Kabel trotz hoher Schüttelbeanspruchungen nicht geschädigt werden.

So ergibt sich ein elektrisches Gerät 11, das bei kostengünstiger Fertigung eine hohe Betriebssicherheit aufweist.

## Patentansprüche

1. Elektrisches Gerät, insbesondere Schalt- und Steuergerät für Kraftfahrzeuge, mit einem Gehäuse (12), das wenigstens eine Ausnehmung (16) aufweist, in der Kontaktelemente (17) zum elektrischen Anschluß des Geräts (11) angeordnet sind, **dadurch gekennzeichnet, daß** an einer Innenwandung (18) der Ausnehmung (16) wenigstens ein Halteelement (19) ausgebildet ist, das quer zu einer Kopplungsrichtung der Kontaktelemente (17) in die Ausnehmung (16) hineinragt und in die Ausnehmung (16) ein Füllkörper (22) zur Bildung eines Steckergehäuses (23) stoffschlüssig einbringbar ist, der vorzugsweise die Ausnehmung (16) verschließt und der in Formschluß mit Lagerabschnitten der Kontaktelemente (17) und dem Halteteil (19) ist.

2. Elektrisches Gerät nach Anspruch 1, **dadurch gekennzeichnet, daß** das Haltelement (19) zumindest mittelbar mit dem Gehäuse (12) verbunden oder Teil des Gehäuses (12) ist.

3. Elektrisches Gerät nach Anspruch 2, **dadurch gekennzeichnet, daß** der Füllkörper (22) durch eine Kunststoffeinspritzung in eine Einspritzform mit Abschnitten der Kontaktelemente (17) und des Gehäuses (12) als Einlegeteile in die Ausnehmung (16) einbringbar ist.

4. Elektrisches Gerät nach Anspruch 3, **dadurch gekennzeichnet, daß** der Füllkörper (22) nach der Kunststoffeinspritzung ein Steckergehäuse (23) bildet und eine Aufnahme (26) für einen Gegenstecker aufweist.

## Claims

1. Electrical apparatus, in particular switching and control apparatus for motor vehicles, having a housing (12) which has at least one recess (16) in which contact elements (17) for making electrical contact with the apparatus (11) are arranged, **characterized in that** at least one securing element (19) which projects into the recess (16) transversely with respect to a coupling direction of the contact elements (17) is formed on an inner wall (18) of the recess (16), and a filler element (22) can be introduced into the recess (16) in a materially connected fashion in order to form a plug housing (23), which filler element preferably closes off the recess (16) and engages in a positively locking fashion with bearing sections of the contact elements (17) and the securing part (19).

2. Electrical apparatus according to Claim 1, **characterized in that** the securing element (19) is connected at least indirectly to the housing (12) or is part of the housing (12).

3. Electrical apparatus according to Claim 2, **characterized in that** the filler element (22) can be introduced into the recess (16) by means of plastic injection moulding in an injection mould with sections of the contact elements (17) and of the housing (12) as insertion parts.

4. Electrical apparatus according to Claim 3, **characterized in that** the filler element (22) forms a plug housing (23) after the plastic injection moulding, and has a recess (26) for a mating plug.

## Revendications

1. Appareil électrique, notamment appareil de commande et de commutation pour véhicules automobiles, avec un boîtier (12), présentant au moins un évidement (16) dans lequel des éléments de contact (17) sont disposés pour le raccordement électrique de l'appareil électrique (11),
**caractérisé en ce qu'**
au moins un élément de butée (19) est formé sur une paroi intérieure (18) de l'évidement (16) et pénètre transversalement dans l'évidement (16) en direction d'un couplage avec les éléments de contact (17), et un corps de remplissage (22) peut être mis en place dans l'évidement (16) par liaison de matière pour former un boîtier de fiche (23), corps qui ferme de préférence l'évidement (16) et qui est en complémentarité de forme avec les segments supports des éléments de contact (17) ainsi qu'avec la pièce de butée (19).

2. Appareil électrique selon la revendication 1,
**caractérisé en ce que**
l'élément de butée ( 19) est au moins relié indirectement au boîtier (12) ou à une partie du boîtier (12).

3. Appareil électrique selon la revendication 2,
**caractérisé en ce que**
le corps de remplissage (22) peut constituer un insert dans l'évidement (16) par injection de carburant dans un moule d'injection délimité par les segments des éléments de contact (17) et le boîtier (12).

4. Appareil électrique selon la revendication 3,
**caractérisé en ce que**
le corps de remplissage (22) forme, après l'injection du carburant, un boîtier de fiche (23) et présente un réceptacle (26) pour fiche femelle.
